(19) Europäisches Patentamt
European Patent Office
Office européen des brevets

(11) **EP 4 535 659 A1**

(12) **EUROPEAN PATENT APPLICATION**

(43) Date of publication:
**09.04.2025 Bulletin 2025/15**

(21) Application number: **23306697.6**

(22) Date of filing: **03.10.2023**

(51) International Patent Classification (IPC):
**H03F 1/02** *(2006.01)*     **H03F 1/56** *(2006.01)*
**H03F 3/60** *(2006.01)*     **H03F 3/195** *(2006.01)*
**H03F 3/213** *(2006.01)*

(52) Cooperative Patent Classification (CPC):
**H03F 1/0288; H03F 1/565; H03F 3/195;**
**H03F 3/213; H03F 3/602;** H03F 2200/222;
H03F 2200/387; H03F 2200/391; H03F 2200/402;
H03F 2200/451

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **NXP USA, Inc.**
**Austin TX 78735 (US)**

(72) Inventors:
• **Nikolayenkov, Oleksandr**
  **31023 Toulouse (FR)**

• **Lamy, Anthony**
  **31023 Toulouse (FR)**
• **Tucker, Geoffrey**
  **31023 Toulouse (FR)**

(74) Representative: **Hardingham, Christopher Mark**
**NXP Semiconductors**
**Intellectual Property Group**
**Abbey House**
**25 Clarendon Road**
**Redhill, Surrey RH1 1QZ (GB)**

Remarks:
Amended claims in accordance with Rule 137(2)
EPC.

(54) **AMPLIFIER DEVICE HAVING A TUNABLE ELEMENT AND METHOD THEREFOR**

(57) An amplifier device includes an input port, an output port, a first amplifier that includes a first input terminal electrically coupled to the input port and a first output terminal electrically coupled to the output port, and a second amplifier that includes a second input terminal electrically coupled to the input port and a second output terminal electrically coupled to the output port. A first network that includes a first tunable element is electrically coupled to the first output terminal and is electrically coupled to a combining node. A second network that includes a second tunable element is electrically coupled to the combining node and electrically coupled to the output port.

FIG. 2A

**Description**

TECHNICAL FIELD

Embodiments of the subject matter described herein relate generally to RF amplifiers.

BACKGROUND

Radio-frequency (RF) amplifiers are increasingly finding use in communications applications. These RF amplifiers are desired because of the lower system size and cost achieved by the need for less cooling capability and because of the reduced energy needed to power these systems. Conventional RF amplifiers (e.g., tuned class-AB) are operated at constant power supply voltages. Moreover, conventional RF amplifiers are operated in a backed-off power condition. This backed-off power condition lowers amplifier efficiency.

Conventional RF amplifiers may experience periods of low traffic conditions. This often means that the amplifiers have reduced efficiency because the amount of amplifier back off increases. This reduced efficiency results in excess energy usage. Thus, amplifier devices with improved efficiency are desired.

BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.

FIG. 1 is a schematic diagram of a conventional amplifier device;
FIGs 2A and 2B are schematic diagrams of an amplifier device in accordance with an example embodiment;
FIGs 3A and 3B are schematic diagrams of an output matching network (OMN) in accordance with an embodiment;
FIG. 4 is a schematic diagrams of an impedance transformer in accordance with an embodiment;
FIGs 5A and 5B are graphical representations depicting operation of the amplifier device of FIG. 2A;
FIG. 6 is a top view of an apparatus 600, according to an embodiment;
FIGs 7-8 are enlarged views of apparatus 600, according to an embodiment; and
FIG. 9 is a flow chart of a method of operation of the amplifier device, according to an embodiment.

SUMMARY

In one aspect, an embodiment includes an amplifier device that may include an input port, an output port, a first amplifier that includes a first input terminal electrically coupled to the input port and a first output terminal electrically coupled to the output port, and a second amplifier that includes a second input terminal electrically coupled to the input port and a second output terminal electrically coupled to the output port. In an embodiment, a first network that includes a first tunable element may be electrically coupled to the first output terminal and may be electrically coupled to a combining node. A second network that includes a second tunable element may be electrically coupled to the combining node and electrically coupled to the output port, according to an embodiment.

An embodiment may include a splitter network that includes a splitter input, a first splitter output, and a second splitter output that electrically couples the input port to the first input terminal at the first split output and electrically couples the input port to the to the second input terminal at the second split output, wherein a first insertion phase between the splitter input and the first splitter output and a second insertion phase between the splitter input and the second splitter output have a phase difference between 60 degrees and 120 degrees. A phase shift network may be electrically coupled between the second output terminal and the combining node.

The first amplifier may be configured as a carrier amplifier and the second amplifier may be configured as a peaking amplifier, according to an embodiment.

The first amplifier may be configured as a peaking amplifier and the second amplifier may be configured as a carrier amplifier, according to an embodiment.

The first network may include a first resonator that includes a first shunt element, wherein the first resonator may be electrically coupled to the first amplifier by the first shunt element and a second shunt element may be electrically coupled to the first shunt element and coupled to a ground potential, according to an embodiment. In an embodiment, a first series element may be electrically coupled to the first resonator. The first network may include a second resonator that includes a third shunt element and a fourth shunt element, wherein the fourth shunt element may be electrically coupled to ground potential, wherein the third shunt element may be electrically coupled to the first series element.

In an embodiment, the first shunt element may include a third tunable element. In an embodiment, the first tunable element may electrically couple the third shunt element of the second resonator to the combining node.

In an embodiment, the first shunt element may include a first inductor, the second shunt element may include a capacitor, the first series element may include a second inductor, the third shunt element may include a third inductor, and the fourth shunt element may include a capacitor.

In an embodiment, the first tunable element may include a first voltage-variable capacitor.

In an embodiment, the third tunable element may include a voltage-variable inductor.

One or more of the first inductor, second inductor, and third inductor may include a variable inductor, according to an embodiment.

In an embodiment, the first tunable element may include a voltage-variable capacitor, wherein the voltage variable capacitor may include one or more varactor diodes, one or more a micro-electro-mechanical switches, and one or more PIN diodes. The first inductor may include micro-electro-mechanical switches and field effect transistor switches.

In an embodiment, the second network may include a voltage-variable impedance transmission line.

The voltage-variable impedance transmission line may include a voltage variable capacitor that electrically couples a transmission line to a ground potential, according to an embodiment.

The voltage-variable capacitor may be selected from the list consisting of varactor diodes, micro-electro-mechanical switches, barium strontium titanate devices, switched capacitors, and one or more PIN diodes, according to an embodiment.

Also disclosed is an apparatus that includes a base substrate, an input port coupled to the base substrate and an output port coupled to the base substrate, a first amplifier die coupled to the base substrate and electrically coupled to a first input terminal and to a first output terminal, and a second amplifier die coupled to the base substrate and electrically coupled to a second input terminal and to a second output terminal. A splitter device may be coupled to the base substrate that electrically couples the input port to the first input terminal and to the second input terminal, according to an embodiment. In an embodiment, an output matching network may be coupled to the base substrate. The output matching network may include a first tunable element, according to an embodiment. In an embodiment, the output matching network may be electrically coupled to the first output terminal and electrically coupled to a combining node. In an embodiment, a reconfigurable impedance transformer may be coupled to the base substrate. The reconfigurable impedance transformer may include a second tunable element coupled to the combining node and to the output port.

The reconfigurable impedance transformer may include a voltage-variable impedance transmission line that includes a voltage variable capacitor that electrically couples a transmission line to a ground potential.

In still another aspect, an embodiment may include a method of operating an amplifier device. An embodiment of the method may include providing an input signal to an input port of the amplifier device, coupling a first portion of the input signal to a first input of the first amplifier and coupling a second portion of the input signal to a second input of the second amplifier, amplifying the first portion of the input signal with the first amplifier to create a first amplified signal at a first output terminal of the first amplifier, and amplifying the second portion of the input signal with the second amplifier to create a second amplified signal at a second output terminal of the second amplifier. An embodiment of the method may further include combining the first amplified signal and the second amplified signal at a combining node to create a combined signal at the combining node. The method may further include, changing an impedance at the first output terminal of the first amplifier, by an output matching network electrically coupled to the first output terminal and electrically coupled to the combining node that includes a first tunable element, and further changing the impedance at the combining node by an impedance transformer that includes a second tunable element electrically coupled to the combining node and an output port, according to an embodiment. The method may also include delivering the combined signal to a load electrically coupled to the output port.

In an embodiment of the method, changing the impedance at the first output terminal of the first amplifier may include realizing a first tuning impedance, by the output matching network, and realizing a second tuning impedance, by the impedance transformer, to operate the first amplifier and the second amplifier in a first state and realizing a third tuning impedance, by the output matching network, and realizing a fourth tuning impedance by the impedance transformer, to operate the first amplifier and the second amplifier in a second state.

In an embodiment of the method, the first state may include a high-power state and the second state may include a low-power state.

In an embodiment of the method, coupling a first portion of the input signal to a first input of the first amplifier and coupling a second portion of the input signal to a second input of the second amplifier may include splitting the input signal using a splitter device, wherein the first portion and second portion of the input signal are offset by a phase difference of between 60 and 120 degrees. Combining the first amplified signal and the second amplified signal includes routing the first amplified signal and the second amplified signal through a phase shift network that has an insertion phase that is within twenty percent of the phase difference, according to an embodiment. In an embodiment, amplifying the first portion of the input signal may include operating the first amplifier device in a configuration selected from the list that includes a peaking amplifier and a carrier amplifier. Moreover, amplifying the second portion of the input signal may include operating the second amplifier device in a configuration selected from the list that includes a peaking amplifier and a carrier amplifier, according to an embodiment.

DETAILED DESCRIPTION

Embodiments of the inventive subject matter, pertaining to amplifier devices and described herein, include an amplifier device configured as a Doherty power amplifier that may include reconfigurable networks enabled by micro electromechanical system (MEMS) switches, voltage variable components fabricated using barium strontium titanate (BST) or similar materials, that are electrically coupled to a combining of the Doherty power amplifier.

The amplifier device embodiments provided herein may overcome some or all of the aforementioned issues with high-efficiency amplifiers. Specifically, the amplifier device embodiments described herein allow the matching impedances presented to peaking amplifiers in a Doherty configuration to be reconfigured to allow improved efficiency for low power operation.

The following detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary, or an example is not necessarily to be construed as preferred or advantageous over other implementations. Furthermore, there is no intention to be bound by any expressed or implied theory presented in the preceding technical field, background, or the following detailed description.

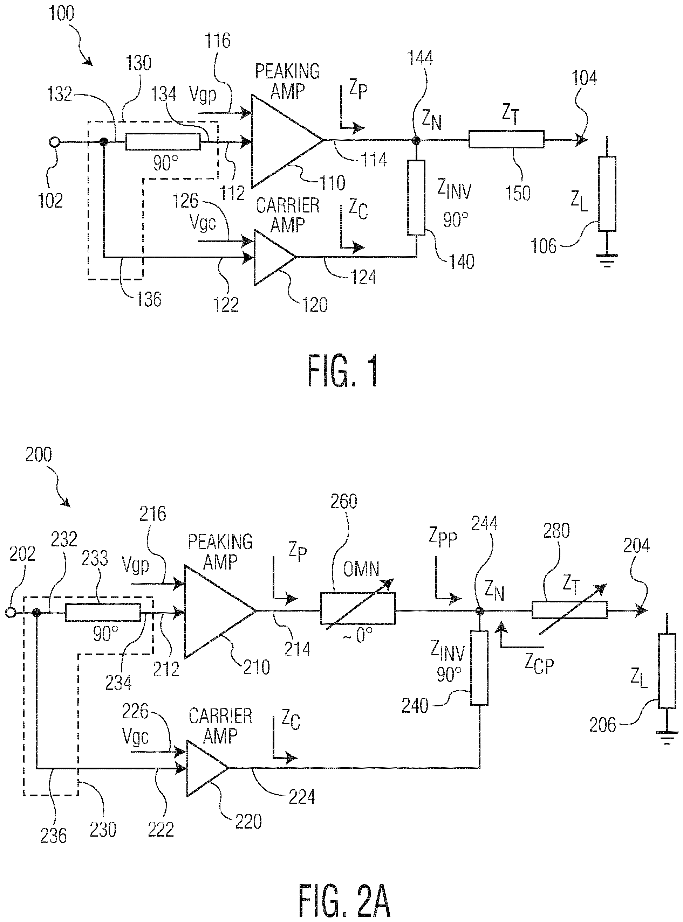

FIG. 1 is a schematic diagram of a Doherty amplifier device 100. A Doherty amplifier device 100 may include an input port 102, an output port 104, a peaking amplifier 110, a carrier amplifier 120, a splitter device 130, a transmission line 140, and an impedance transformer 150.

For Doherty amplifier device 100, input port 102 is connected to input 132 of splitter device 130. First output 134 of splitter device 130 is connected to first input terminal 112 of peaking amplifier 110. Second output 136 of splitter device 130 is connected to second input terminal 122 of carrier amplifier 120. First output terminal 114 of peaking amplifier 110 is connected to transmission line 140 at combining node 144. Second output terminal 124 of carrier amplifier 120 is connected to transmission line 140. Output impedance transformer 150 couples the combining node 144 to the output port 104 and output load 106.

Peaking amplifier 110 may include, e.g., a GaN HFET device, wherein the first gate bias 116, Vgp, of peaking amplifier 120 is set to achieve a class C bias. As used herein, the term "class C bias" means that a final transistor stage of an amplifier is biased in an off-state such that the final stage has a gate bias whose value is more than 100 mV below the threshold voltage of the final stage transistor. In this case, $I_{DQ}$ is limited to the leakage current of the transistor. In an example, $I_{DQ}$ is less than 1 mA/mm for class C operation. In this example, peaking amplifier 110 has an output stage that includes a GaN HFET with a total gate periphery of approximately 4 millimeters.

Likewise, carrier amplifier 120 may include a radio frequency transistor (e.g., gallium nitride (GaN) heterojunction field effect transistor (HFET)). During operation, second gate bias 126, Vgc, of carrier amplifier 120 is set to achieve a class AB bias. As used herein, the term "class AB bias" means that a final transistor stage of an amplifier is biased in forward active mode such that the final stage has a quiescent current ($I_{DQ}$) that exceeds more than 0.5 percent of the maximum current of the final stage. In this example, the output stage of carrier amplifier 120 includes a GaN HFET with a total gate periphery of approximately 2 millimeters. The current density of the GaN HFET is approximately 1 ampere per millimeter of gate periphery (i.e., 1 A/mm). The maximum current of the output stage transistor is approximately 2 amperes. Thus, the carrier amplifier 120 is biased in class AB when the $I_{DQ}$ of the output stage transistor exceeds 5 mA/mm or 10 mA of total drain current.

Peaking amplifier 110 and carrier amplifier 120 are typically designed to have an asymmetry ratio given by

$$\beta = \frac{Peaking\ Periphery}{Carrier\ Periphery}$$

(1)

In this example, the value of β is 2.

During operation of Doherty amplifier 100, carrier amplifier 120 amplifies portion of signal applied to input port 102 that arrives in first splitter output 136. When signal strength is low enough that peaking amplifier 110 is not active, only the carrier amplifier 120 amplifies the signal. In this case, the impedance presented to the carrier amplifier depends on the characteristic impedance $Z_{INV}$ of transmission line 140 and the combining node impedance $Z_N$ seen at combining node 144. The impedance $Z_C$ seen at combining node 144 is given by

$$Z_C = \frac{Z_{INV}^2}{Z_N}. \tag{2}$$

When the input signal presented to second input 112 of peaking amplifier 110 is large enough to turn on the class C biased transistor, peaking amplifier 110 will amplify the signal. At full power, the impedance, $Z_p$, seen by peaking amplifier 110 is given by

$$Z_P = \frac{Z_N(1 + \beta)}{\beta}. \tag{3}$$

The impedance, $Z_N$, seen at combining node 144 is given by

$$Z_N = \frac{Z_{INV}}{(1 + \beta)}. \tag{4}$$

The impedance of transformer 150 is given by

$$Z_T = \sqrt{Z_N Z_L}. \tag{5}$$

FIG. 2A is a schematic diagram of an amplifier device 200 in accordance with an example embodiment. Amplifier device 200 may include an input port 202, an output port 204, a peaking amplifier 210 (i.e. "first amplifier") that includes a first input terminal 212 electrically coupled to the input port 202 and a first output terminal 214 electrically coupled to the output port 204 and output load 206, and a carrier amplifier 220 (i.e., second amplifier) that includes a second input terminal 222 electrically coupled to the input port 202 and a second output terminal 224 electrically coupled to the output port 204 and output load 206.. Amplifier device 200 allows efficiencies at lower average power during low traffic hours by including the reconfigurable output matching network (OMN) 260 (i.e., "first network") and the reconfigurable impedance transformer 280 (i.e., "second network"). In an embodiment, the reconfigurable OMN 260 may be electrically coupled to the first output terminal 214 and may be electrically coupled to a combining node 244. The reconfigurable impedance transformer 280 may be electrically coupled to the combining node 244 and electrically coupled to the output port 204, according to an embodiment.

Peaking amplifier 210 may include, e.g., a GaN HFET device, wherein first gate bias 216, $V_{gp}$, of peaking amplifier 210 is set to achieve a class C bias. In this case, $I_{DQ}$ is limited to the leakage current of the transistor. In an example, $I_{DQ}$ is less than 1 mA/mm for class C operation. In this example, peaking amplifier 210 has an output stage that includes a GaN HFET with a total gate periphery of approximately 4 millimeters.

Carrier amplifier 220 may include a radio frequency transistor (e.g., gallium nitride (GaN) heterojunction field effect transistor (HFET)). During operation, second gate bias 226, $V_{gc}$, of carrier amplifier 220 may be set to achieve a class AB bias. In this example, the output stage of carrier amplifier 220 includes a GaN HFET with a total gate periphery of approximately 2 millimeters. The maximum current of the output stage transistor may be approximately 2 amperes. Thus, the carrier amplifier 220 is biased in class AB when the $I_{DQ}$ of the output stage transistor exceeds 5 mA/mm or 10 mA of total drain current.

An embodiment may include a splitter network 230 that includes a splitter input 232, a first splitter output 234, and a second splitter output 236 that electrically couples the input port 202 to the first input terminal 212 at the first splitter output 234 and electrically couples the input power to the to the second input terminal 222 at the second split output 236, wherein a first insertion phase between the splitter input 232 and the first splitter output 234 and a second insertion phase between the splitter input and the second splitter output may have a phase difference between 60 degrees and 120 degrees. An impedance inverter network 240 (i.e., "phase shift network") may be electrically coupled between the first output terminal 214 and the combining node 244.

To reduce the Doherty Amplifier power by n times, a n-fold increase in the optimum impedance, and consequently, an *n*-fold reduction in the power of carrier amplifier 210 and peaking amplifier 220. Thus, in an embodiment, for a

power level, $P_{out}$, reduced by a factor of $n$ or, $P_{out}/n$, by Eq. (2) the carrier amplifier impedance is given by

$$Z_C = \frac{Z_{INV}^2}{Z_{Nn}} = n * \frac{Z_{INV}^2}{Z_N}$$

$$(6)$$

where $Z_{Nn} = \frac{Z_N}{n}$. To maintain the same power ratio between the peaking amplifier 210 and carrier amplifier 220, peaking amplifier 210 should have its impedance increased by a factor of $n$, according to an embodiment:

$$Z_P = n * \frac{Z_N(1+\beta)}{\beta}$$

$$(7)$$

In an embodiment, the peaking path impedance on the combining node side at reduced power is given by:

$$Z_{PPn} = \frac{Z_{Nn} * (1 + \beta)}{\beta} = \frac{1}{n} * \frac{Z_N(1 + \beta)}{\beta}$$

$$(8)$$

To enable the n-fold increase in carrier and peaking optimum impedances, combining node needs to be reduced by n thus, the impedance seen at the combining node 244 at reduced power is given by

$$Z_{Nn} = \frac{Z_N}{n}$$

$$(9)$$

The reduced characterisic impdance of reconfigurable impedance tranformer 280 is given by

$$Z_T = \sqrt{Z_{Nn} Z_L}$$

$$(10)$$

In an embodiment, and to satisfy the condition of Eq. (7), the reduced impedance for the low power state, $Z_{PPn}$, is achieved by reducing an impedance of the reconfigurable OMN 260. To satisfy the condition of Eq. (10), the impedance of the reconfigurable impedance transformer 280 is reduced, according to an embodiment.

In an example embodiment, the parameters for full power mode and a mode with 3 dB less than full power mode are used to realize amplifier device 200.

| Parameter | Full power mode | $P_{avg}$ - 3 dB mode |
|---|---|---|
| $\beta$ | 2 | 2 |
| $Z_C$ | 150 Ohm | 300 Ohm |
| $Z_{INV}$ | 50 Ohm | 50 Ohm |
| $Z_P$ | 25 Ohm | 50 Ohm |
| $Z_N$ | 16.6 Ohm | -- |
| $Z_{Nn}$ | -- | 8.3 Ohm |

(continued)

| Parameter | Full power mode | $P_{avg}$ - 3 dB mode |
|---|---|---|
| $Z_T$ | 28.8 Ohm | 20.4 Ohm |

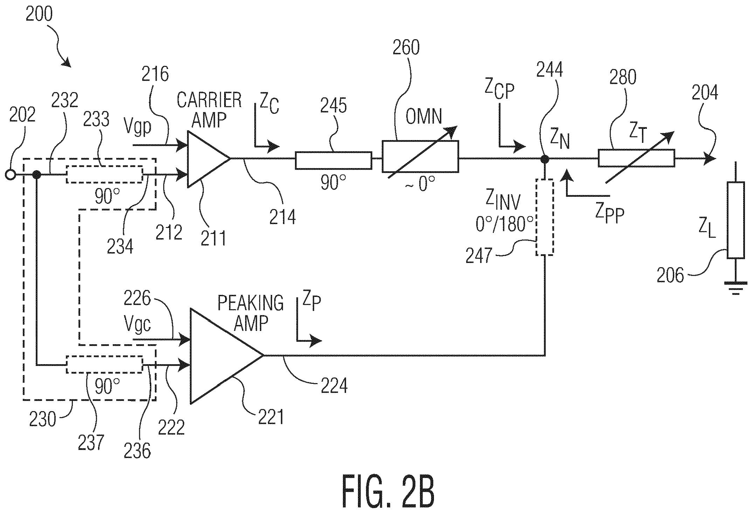

In the example embodiment discussed above, the first amplifier 210 is configured as a peaking amplifier and the second amplifier 220 is configured as a carrier amplifier. In other embodiments, and as shown in FIG. 2B, a first amplifier 211 may be configured as a carrier amplifier and a second amplifier 221 may be configured as a peaking amplifier, according to an embodiment. In these other embodiments, an additional transmission line 245 or other phase delay device having a phase shift of, e.g., 90 degrees may be placed between the first amplifier 211 and the OMN 260. In these embodiments, the phase shift associated with phase shift network247 may be approximately 180 degrees. In still other embodiments, the phase shift associated with phase shift network 247 may be approximately zero degrees (i.e., phase shift network is omitted or simply implemented as a network with zero phase shift). In these still other embodiments, the phase delay element 233 of splitter device 230, e.g., 90 degrees, may be omitted and phase delay element 237 may be placed between the splitter input 232 and the second splitter output 236 of the splitter device 230, when first amplifier 211 is configured as a carrier amplifier and second amplifier 221 is configured as a peaking amplifier. In these other embodiments and still other embodiments, the impedance at $Z_N$ presented by the reconfigurable impedance transformer 280 and the impedance, Zc, presented to the first amplifier 211 when implemented as a carrier amplifier may be increased in low power mode. In these other embodiments, other components, e.g., the phase shift network 247 and OMN 260 may be optimized to account for, e.g., higher optimum impedance, Zc, for the carrier amplifier 211 and, $Z_P$, the peaking amplifier 221 as well as other differences between the carrier and peaking amplifier.

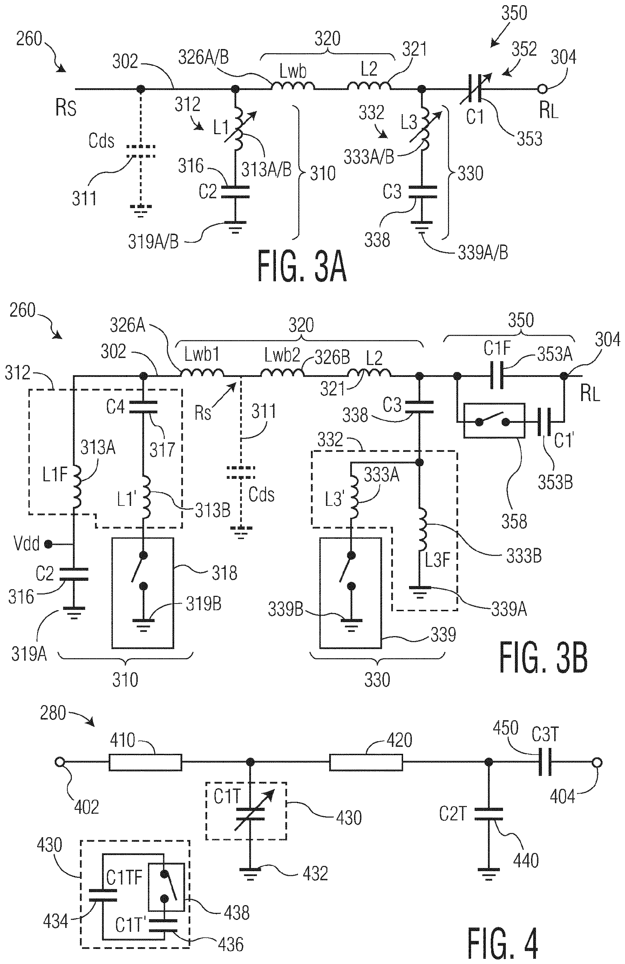

FIGs 3A and 3B, referred collectively to FIG. 3, are schematic diagrams of the output matching network (OMN) 260 in accordance with an embodiment. The following descriptions are best understood by viewing FIGs 3A and 3B together.

According to an embodiment, the reconfigurable OMN 260 may include an input 302, output 304, first resonator 310, series element 320, second resonator 330, and output element 350. Input 302 may be electrically coupled to first resonator 310, first resonator 310 may be electrically coupled to series element 320, series element 320 may be electrically coupled to second resonator 330, and second resonator 330 may be electrically coupled to output element 350, according to an embodiment.

In an embodiment, first resonator 310 may include first resonator inductance 312 (i.e., "first shunt element"), L1, coupled to the input 302 and a first capacitor 316 (i.e., "second shunt element"), C2, wherein first capacitor 316 couples to the first resonator inductance 312 to ground 319A/B. In an embodiment, output capacitance 311, $C_{ds}$, of active devices (e.g., final stage transistor output capacitance of first amplifier 210) may be coupled to the reconfigurable OMN 260 at input 302 and may be considered in the design of reconfigurable OMN 260. First resonator inductance 312 may include a first variable inductor 313A/B ("i.e., "third tunable element"). As seen in the example embodiment of FIG. 3B, variable inductor 313A/B may include a first fixed inductor 313A, L1F, that couples to first capacitor 316, C2. A first variable inductor 313B, L1', may be coupled to input 302 via capacitor 317, C4. First switch 318 may couple first variable inductor 313B, L1', to ground 319B, according to an embodiment. In other embodiments (not shown), alternative topologies for realizing first resonator inductance 312 may be used without limitation.

According to an embodiment, first resonator inductance 312, L1, may have an upper tuning range value (e.g., in embodiment of FIG. 3B, when first switch 318 is open and value is defined by first fixed inductor 313A, L1F) of between about 2 nanohenries (nH) and about 10 nH, according to an embodiment. In other embodiments, first resonator inductance 312, L1, may have an upper tuning range value of between about 0.1 nanohenries (nH) and about 50 nH, according to an embodiment, although other higher or lower values may be used. In an embodiment, first resonator inductance 312, L1, may have a lower tuning range value (e.g., in embodiment of FIG. 3B, when first switch 318 is closed and the value of first resonator inductor 312 L1 is approximated by the parallel combination of first fixed inductor 313A, L1F and first variable inductor 313B, L1') of between about 0.2 nanohenries (nH) and about 1 nH, according to an embodiment. In other embodiments, first resonator inductance 312, L1, may have a lower tuning range value of between about 0.01 nanohenries (nH) and about 10 nH, according to an embodiment, although other higher or lower values may be used.

In an embodiment, series element 320, L2 may electrically couple first resonator 310 to second resonator 330. In an embodiment, series element 320 may include inductor 321. According to an embodiment, a bond wire inductance 326A/B, Lwb, may be included in series element 320. In other embodiments (e.g., monolithically integrated implementation), bond wire inductance 326A/B may be omitted.

In an embodiment, second resonator 330 may be electrically coupled to series element 320 and may include second resonator inductance 332 (i.e., "third shunt element"), L3, coupled to the input 302 through series element 320, and a second capacitor 338 (i.e., "fourth shunt element"), C3, wherein second capacitor 338 may couple to the second resonator inductance 332 to ground 339A/B. Second resonator inductance 332 may include a second variable inductor 333A/B. As seen in the example embodiment of FIG. 3B, second variable inductor 333A/B may include a first fixed inductor 333B, L3F, that couples to second capacitor 338, C3. A first variable inductor 333A, L3', may be coupled to input 302 via series element 320. Second switch 339 may couple first variable inductor 333A, L3', to ground 339B, according to an embodiment. In other embodiments (not shown), alternative topologies using various series and/or parallel combinations of inductors and/or capacitors for realizing first resonator inductance 332 may be used without limitation.

According to an embodiment, second resonator inductance 332, L3, may have an upper tuning range value (e.g., in embodiment of FIG. 3B, when second switch 338 is open and value is defined by first fixed inductor 333A, L1F) of between about 2 nanohenries (nH) and about 10 nH, according to an embodiment. In other embodiments, second resonator inductance 332, L3, may have an upper tuning range value of between about 0.1 nanohenries (nH) and about 50 nH, according to an embodiment, although other higher or lower values may be used. In an embodiment, second resonator inductance 332, L3, may have a lower tuning range value (e.g., in embodiment of FIG. 3B, when second switch 339 is closed and the value of second resonator inductance 332, L3, is approximated by the parallel combination of second fixed inductor 333B, L3F, and second variable inductor 333A, L3') of between about 0.2 nanohenries (nH) and about 1 nH, according to an embodiment. In other embodiments, first resonator inductance 332, L3, may have a lower tuning range value of between about 0.01 nanohenries (nH) and about 10 nH, according to an embodiment, although other higher or lower values may be used.

In an embodiment, output element 350 (i.e., "first tunable element") may electrically couple second resonator 330 to output 304 and to the combining node 244. Output element 350 may include capacitance element 352, C1. In an embodiment, capacitance element 352, C1, may include fixed capacitor 353A, C1F. Variable capacitor 353B, C1' may be coupled to output 304 and may be electrically coupled in parallel with fixed capacitor 353A, C1F, when third switch 358 is closed, according to an embodiment. In an embodiment, the overall capacitance value of output element 350 may toggle between C1F when third switch 358 is open and C1F+C1' when third switch 358 is closed.

According to an embodiment, capacitance element 352, C1, may have a lower tuning range value (e.g., in embodiment of FIG. 3B, when third switch 358 is open and value is defined by first fixed capacitor 353A, C1F) of between about 0.2 picofarads (pF) and about 10 pF, according to an embodiment. In other embodiments, capacitance element 352, C1, may have a lower tuning range value of between about 0.01 pF and about 100 pF, according to an embodiment, although other higher or lower values may be used. In an embodiment, capacitance element 352, C1, may have an upper tuning range value (e.g., in embodiment of FIG. 3B, when third switch 358 is closed and the value of capacitance element 352, C1, is approximated by the parallel combination of fixed capacitor 353A, C1F, and variable capacitor 353B, C1') of between about 0.5 pF and about 20 pF, according to an embodiment. In other embodiments, capacitance element 352 may have an upper tuning range value of between about 0.1 pF and about 100 pF, according to an embodiment, although other higher or lower values may be used.

Variable capacitances 352 and first and second resonator inductances 312, 332 may be implemented using micro-electro-mechanical switch to realize switches 318, 339, 358, according to an embodiment. In other embodiments, transistor switches may be used to realize the switched elements. In still other embodiments, the voltage-variable capacitances may be realized using varactor diodes, switched capacitors, and one or more PIN diodes, according to an embodiment.

In an example embodiment, the values for $R_s$, $R_L$ presented to the first amplifier 210 and combining node 244 and an insertion phase, Iph through the reconfigurable OMN 260 in full power mode and the half power mode take the values in the table below, calculated by circuit simulation in the full power mode to a mode at half power.

| Mode | Rs, Ohm | L1, nH | L2, nH | L3, nH | C1, pF | IL, dB | IPh, ° | RL, Ohm |
|---|---|---|---|---|---|---|---|---|
| Full Power | 25 | 0.6 | 0.6 | 12 | 2.3 | -0.133 | -3.17 | 25.4 |
| Pavg - 3 dB | 50 | 6.2 | 0.6 | 0.6 | 3.2 | -0.215 | -3.66 | 12.5 |

FIG. 4 is a schematic diagrams of reconfigurable impedance transformer 280 (i.e., "second network"), in accordance with an embodiment. In an embodiment, the reconfigurable impedance transformer 280 may be realized using a voltage-variable transmission line.

The reconfigurable impedance transformer 280 may include an input 402, a short transmission line section 410, voltage variable capacitance 430 ("i.e., second tunable element"), C1T, that electrically couples a transmission line 420 to a ground potential 432, and a fixed capacitance 440, C2T, according to an embodiment. A series capacitor 450, C3T, may be used to couple the "pi" network of voltage variable capacitance 430, transmission line 420, and fixed capacitance 440 to output 404.

In an embodiment, voltage variable capacitance 430, C1T, may include fixed capacitor 434, C1TF. Variable capacitance 436, C1T' may be electrically coupled in parallel with fixed capacitor 434, C1F, when switch 438 is closed, according to an embodiment. In an embodiment, the overall capacitance value of voltage variable capacitance may toggle between C1TF when switch 438 is open and C1TF+C1T' when switch 438 is closed.

Voltage variable capacitance 430, C1T may be implemented using micro-electro-mechanical switch to realize switch 438, according to an embodiment. In other embodiments, the voltage-variable capacitance 430, CIT may be realized using varactor diodes, switched capacitors, and one or more PIN diodes, according to an embodiment.

According to an embodiment, voltage variable capacitance 430, C1T, may have a lower tuning range value (e.g., when switch 438 is open and value is defined by first fixed capacitor 434, C1TF) of between about 0.2 picofarads (pF) and about 10 pF, according to an embodiment. In other embodiments, voltage-variable capacitor 430, C1T, may have a lower tuning range value of between about 0.01 pF and about 100 pF, although other higher or lower values may be used. In an embodiment, voltage variable capacitor, C1T, may have an upper tuning range value (e.g., when switch 438 is closed and the value of voltage variable capacitor C1T, is approximated by the parallel combination of fixed capacitor 434, C1F, and variable capacitor 430, C1T') of between about 0.5 pF and about 20 pF, according to an embodiment. In other embodiments, voltage variable capacitor 430 may have an upper tuning range value of between about 0.1 pF and about 100 pF, according to an embodiment, although other higher or lower values may be used.

In an example embodiment, the values for $R_s$ presented to the combining node 244 and the insertion phase, IPh, of the reconfigurable transformer 280 take the values in the table below calculated by simulation as the components of the reconfigurable impedance transformer 280 in full power mode and the half power mode.

| Mode | Rs, Ohm | C1, pF | C2, pF | IL, dB | IPh, ° | RL, Ohm |
|---|---|---|---|---|---|---|
| Full Power | 16.6 | 0.58 | 0.6 | -0.127 | -79.71 | 50 |
| Pavg - 3 dB | 8.3 | 1.5 | 0.6 | -0.227 | -92.81 | 50 |

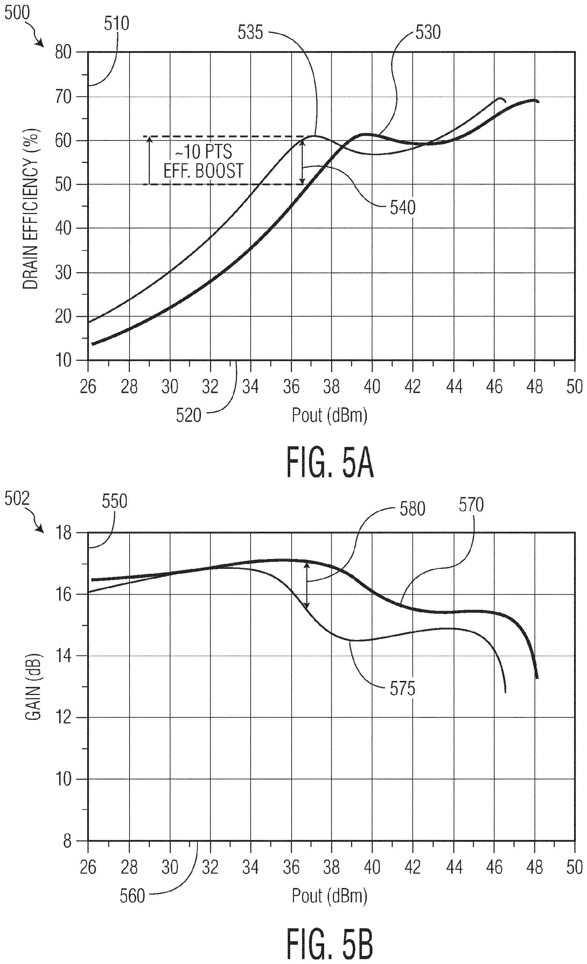

FIGs 5A and 5B are graphical representations 500, 502 depicting operation of the amplifier device 200 of FIG. 2A. The performance of amplifier device 200 may be best understood by viewing FIGs 5A and 5B simultaneously.

FIG 5A depicts simulated drain efficiency 510 versus average output power 520. Traces 530 and 535 depict the drain efficiency of the amplifier device 200 in high power and low power mode, respectively. Likewise, Traces 570 and 575 depict simulated gain 550 versus average output power 560 of the amplifier device 200 in high power and low power mode, respectively. As seen comparing traces 530, 535, an efficiency improvement 540 of approximately 10 percentage points is seen for the low power mode at a 37 dBm power level, according to an embodiment. As seen comparing traces 570, 575, a gain reduction 580 of approximately 1.5 dB is seen for the low power mode at the 37 dBm power level, according to an embodiment.

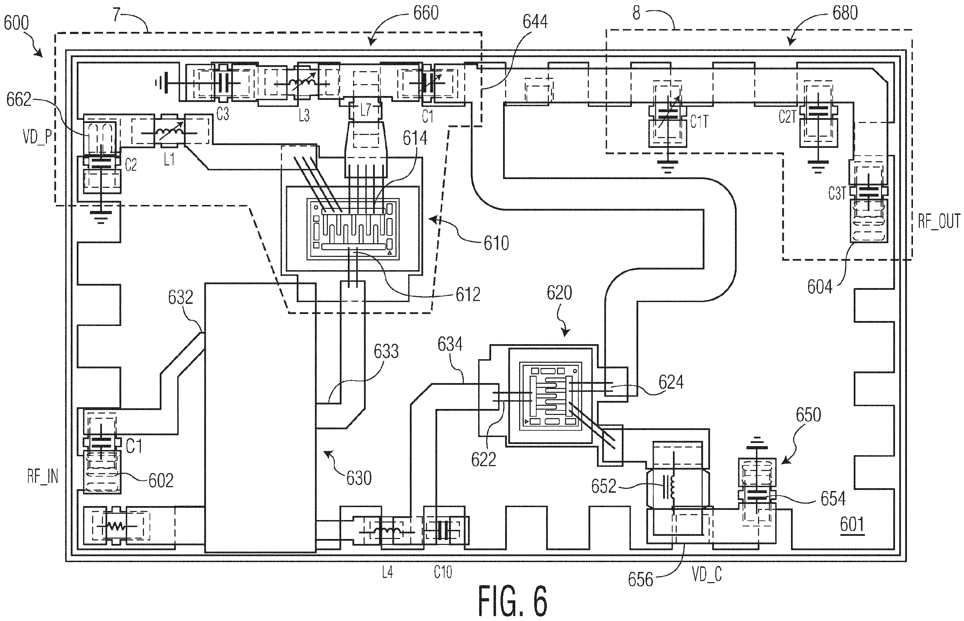

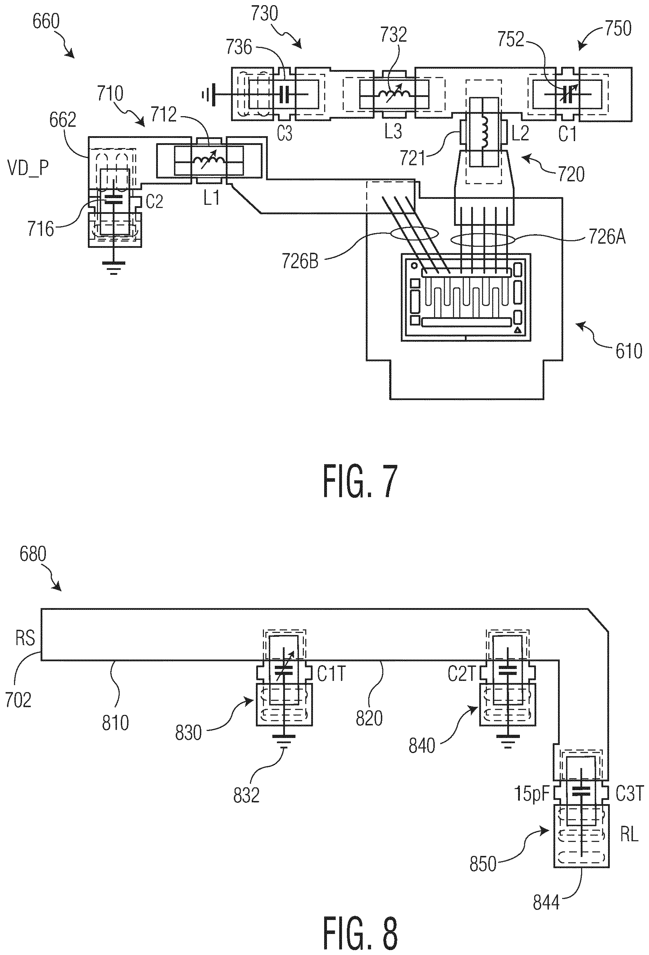

FIGs 6 is a top view of an apparatus 600, according to an embodiment. FIGs 7 and 8 show details of regions 7 and 8 within FIG. 6. FIG 6 may be best understood when viewed simultaneously with FIGs 7 and 8. An embodiment of the apparatus 600 may include a base substrate 601, an input port 602 coupled to the base substrate 601, an output port 604 coupled to the base substrate 601, a peaking amplifier die 610 (i.e., "first amplifier die") coupled to the base substrate 601 and electrically coupled to a first input terminal 612 and to a first output terminal 614, and a carrier amplifier die 620 (i.e., "second amplifier die") coupled to the base substrate 601 and electrically coupled to a second input terminal 622 and to a second output terminal 624. A splitter device 630 that includes splitter input 632 and outputs 633, 634 may be coupled to the base substrate 601 that electrically couples the input port 602 to the first input terminal 612 and to the second input terminal 622, according to an embodiment. In an embodiment, a reconfigurable output matching network (OMN) 660 may be coupled to the base substrate 601. In an embodiment, the reconfigurable OMN 660 may be electrically coupled to the first output terminal 614 and electrically coupled to a combining node 644. In an embodiment, a voltage impedance transformer 680 may be coupled to the base substrate 601. The impedance transformer 680 may include a voltage variable capacitor 830 (i.e., "second tunable element") electrically coupled to the combining node 644 and to the output port 604. In an embodiment, bias network 650 that includes choke 652 and bypass capacitor 654, may be used to supply carrier drain bias 656, $V_{D\_C}$ to carrier amplifier die 620. Likewise, in an embodiment, peaking drain bias 662, $V_{D\_P}$, may be supplied through reconfigurable OMN 660.

FIG. 7 shows a detailed view of reconfigurable OMN 660 and its electrical connections to peaking amplifier die 610, according to an embodiment. The reconfigurable OMN 660 may include an output element 750, according to an embodiment. In an embodiment, the output element 750 may include a first voltage-variable capacitor 752 (i.e., "first tunable element").

According to an embodiment, the reconfigurable OMN 660 may include first resonator 710, series element 720, second resonator 730, and output element 750. First resonator 710 may be electrically coupled to series element 720, series element 720 may be electrically coupled to second resonator 730, and second resonator 730 may be electrically coupled to output element 750, according to an embodiment.

First resonator 710 may include first tunable inductor 712 and first capacitor 716, according to an embodiment. Peaking amplifier drain bias 662 may be applied to peaking amplifier die through first tunable inductor 712 and bond wire 726B, wherein first capacitor 716 may be used to decouple a DC bias supply (not shown) that supplies peaking amplifier

**EP 4 535 659 A1**

drain bias 662 from first tunable inductor 712, according to an embodiment.

In an embodiment, series element 720, may include inductor component 721, L2, and may electrically couple first resonator 710 to second resonator 730. According to an embodiment, bond wires 726A/B, may be included in series element 720. In other embodiments (e.g., monolithically integrated implementation), bond wires 726A/B may be omitted.

In an embodiment, second resonator 730 may be electrically coupled to series element 720 and may include second tunable inductor 732 (i.e., "third shunt element"), L3, and a second capacitor component 736 (i.e., "fourth shunt element"), C3, wherein second capacitor component 736 may couple to the second resonator inductor component 732 to ground.

In an embodiment, output element 750 may electrically couple second resonator 330 to output 304. Output element 750 may include capacitance element 752, C1. In an embodiment, capacitance element 752 may be a voltage-variable capacitor.

In an embodiment, voltage variable capacitance 752, C1T may be implemented using micro-electro-mechanical switches according to an embodiment. In other embodiments, the voltage-variable capacitance 752, CIT may be realized using barium strontium titanate (BST) based capacitors, barium strontium zirconate (BZT) based capacitors, varactor diodes, switched capacitors, and one or more PIN diodes, according to an embodiment. In an embodiment, control circuitry (not shown) may be used to control the capacitance of voltage variable capacitance 752.

FIG. 8 shows a detailed view of reconfigurable impedance transformer 680 (i.e., "second network"), according to an embodiment. In an embodiment, the reconfigurable impedance transformer 680 may include a transmission line 820 that includes a voltage variable capacitor 830, C1T that electrically couples a transmission line 820 to a ground potential.

The reconfigurable impedance transformer 680 may include input transmission line section 810, variable capacitance 830, C1T, that electrically couples a transmission line 820 to a ground potential 832, and a fixed capacitance 840, C2T, according to an embodiment. A series capacitor 850, C3T, may be used to couple the "pi" network of voltage variable capacitance 830, transmission line 820, and fixed capacitance 840.

Voltage variable capacitance 830, C1T may be implemented using micro-electro-mechanical switches according to an embodiment. In other embodiments, the voltage-variable capacitance 430, CIT may be realized using barium strontium titanate (BST) based capacitors, barium strontium zirconate (BZT) based capacitors, varactor diodes, switched capacitors, and one or more PIN diodes, according to an embodiment.

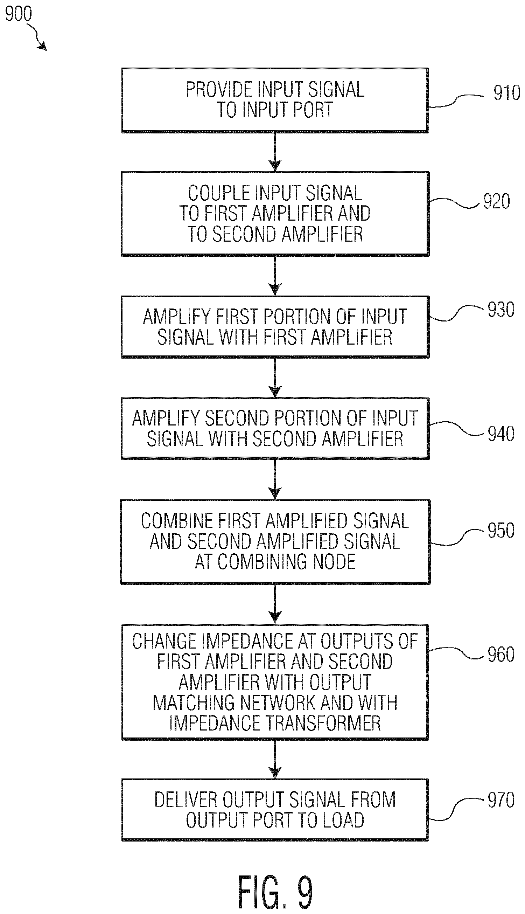

FIG. 9 is a flow chart of a method of operation of the amplifier device 200, according to an embodiment. The method may be best understood by simultaneously viewing FIG. 9 alongside FIGs 2-4.

In blocks 910-940, an embodiment of the method may include providing an input signal to an input port 202 of the amplifier device 200, coupling a first portion of the input signal to first input 212 of the peaking amplifier 210 (i.e., "first amplifier") and coupling a second portion of the input signal to a second input 222 of the carrier amplifier 220 (i.e., "second amplifier"), amplifying the first portion of the input signal with the peaking amplifier 210 to create a first amplified signal at a first output terminal 214 of the peaking amplifier 210, and amplifying the second portion of the input signal with the carrier amplifier 220 to create a second amplified signal at a second output terminal 224 of the carrier amplifier.

In block 950, an embodiment of the method may further include combining the first amplified signal and the second amplified signal at combining node 244 to create a combined signal at the combining node.

In block 960, the method may further include, changing an impedance at the peaking amplifier output 214, by the reconfigurable OMN 260 electrically coupled to the first output terminal and electrically coupled to the combining node 244 that includes output element 350 that includes a first voltage variable capacitor 353 (i.e., "first tunable element"), and further changing the impedance at the combining node 244 by a reconfigurable impedance transformer 280 that includes a second voltage variable capacitor 430 (i.e., "second tunable element") electrically coupled to the combining node 244 and output port 404, according to an embodiment. It should be appreciated that changing an impedance at the peaking amplifier output 214, by the reconfigurable OMN 260 may include changing an impedance at the carrier amplifier output 224, according to an embodiment.

Still referring to FIG. 9, block 960, in an embodiment of the method, changing the impedance at the combining node 244 may include realizing a first tuning impedance, by the reconfigurable OMN 260, and realizing a second tuning impedance, by the reconfigurable impedance transformer 280, to operate the peaking amplifier 210 and the carrier amplifier 220 in a full power mode (i.e., "first state") and realizing a third tuning impedance, by the reconfigurable OMN 260, and realizing a fourth tuning impedance by the impedance transformer 280, to operate the peaking amplifier 210 and the carrier amplifier 210 in a low power mode (i.e., "second state"). Referring to FIG. 9, block 970, the method may also include delivering the combined signal to a load 206 electrically coupled to the output port 204 of FIG. 2A.

Referring again to FIG 9, block 920, in an embodiment of the method, coupling a first portion of the input signal to a first input of the first amplifier and coupling a second portion of the input signal to a second input of the second amplifier may include splitting the input signal using a splitter device 230, wherein the first portion and second portion of the input signal are offset by a phase difference of between 60 and 120 degrees. Combining the first amplified signal and the second amplified signal includes routing of the first amplified signal and the second amplified signal through an impedance inverter network 240 that has an insertion phase that is within twenty percent of the phase difference, according to an embodiment.

10

Referring again to FIG 9, blocks 930-940, in an embodiment, amplifying the first portion of the input signal may include operating the first amplifier device 210 as a peaking amplifier 210 or a carrier amplifier 220. Moreover, amplifying the second portion of the input signal may include operating the second amplifier 220 as a peaking amplifier or a carrier amplifier, according to an embodiment.

For the sake of brevity, certain terminology may also be used herein for the purpose of reference only, and thus are not intended to be limiting, and the terms "first," "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

**Claims**

1. An amplifier device comprising:

   an input port;
   an output port;
   a first amplifier that includes a first input terminal electrically coupled to the input port and a first output terminal electrically coupled to the output port;
   a second amplifier that includes a second input terminal electrically coupled to the input port and a second output terminal electrically coupled to the output port;
   a first network that includes a first tunable element electrically coupled to the first output terminal and electrically coupled to a combining node; and
   a second network than includes a second tunable element that is electrically coupled to the combining node and electrically coupled to the output port.

2. The amplifier device of claim 1, wherein the amplifier device is configured as a Doherty amplifier comprising:

   a splitter network that includes a splitter input, a first splitter output, and a second splitter output that electrically couples the input port to the first input terminal at the first split output and that electrically couples the input port to the second input terminal at the second split output, wherein a first insertion phase between the splitter input and the first splitter output and a second insertion phase between the splitter input and the second splitter output have a phase difference between 60 degrees and 120 degrees; and
   a phase shift network electrically coupled between the second output terminal and the combining node.

3. The amplifier device of claim 1 or 2, wherein a one of: the first amplifier is configured as a peaking amplifier and the second amplifier is configured as a carrier amplifier, and the first amplifier is configured as a carrier amplifier and the second amplifier is configured as a peaking amplifier.

4. The amplifier device of any preceding claim, wherein the first tunable element includes a first voltage-variable capacitor.

**5.** The amplifier device of any preceding claim, wherein the first network comprises:

a first resonator that includes a first shunt element, wherein the first resonator is electrically coupled to the first amplifier by the first shunt element;
a second shunt element electrically coupled to the first shunt element and coupled to ground potential;
a first series element electrically coupled to the first resonator;
a second resonator that includes a third shunt element, wherein the third shunt element is electrically coupled to the first series element; and
a fourth shunt element electrically coupled to ground potential.

**6.** The amplifier device of claim 5, wherein:

the first shunt element includes a third tunable element; and
the first tunable element electrically couples the third shunt element of the second resonator to the combining node.

**7.** The amplifier device of claim 5 or 6, wherein:

the first shunt element includes a first inductor;
the second shunt element includes a capacitor;
the first series element includes a second inductor;
the third shunt element includes a third inductor; and
the fourth shunt element includes a capacitor.

**10.** The amplifier device of claim 7, wherein one or more of the first inductor, second inductor, and third inductor include a variable inductor.

**9.** The amplifier device of claim 10, wherein the first tunable element includes a voltage-variable capacitor, wherein:

the voltage-variable capacitor includes components selected from the group consisting of one or more varactor diodes, one or more a micro-electro-mechanical switches, and one or more PIN diodes; and
the first inductor includes components selected from the group consisting of micro-electro-mechanical switches and field effect transistor switches.

**10.** The amplifier device of any preceding claim, wherein the second network includes a voltage-variable impedance transmission line.

**11.** The amplifier device of claim 10, wherein the voltage-variable impedance transmission line includes a voltage-variable capacitor that electrically couples a transmission line to a ground potential.

**12.** The amplifier device of claim 11, wherein the voltage-variable capacitor is selected from the group consisting of one or more varactor diodes, one or more a micro-electro-mechanical switches, and one or more PIN diodes, barium strontium titanate devices, barium zirconate titanate devices.

**13.** A method of operating an amplifier device, the method comprising the steps of:

providing an input signal to an input port of the amplifier device;
coupling a first portion of the input signal to a first input of a first amplifier and coupling a second portion of the input signal to a second input of a second amplifier;
amplifying the first portion of the input signal with the first amplifier to create a first amplified signal at a first output terminal of the first amplifier;
amplifying the second portion of the input signal with the second amplifier to create a second amplified signal at a second output terminal of the second amplifier;
combining the first amplified signal and the second amplified signal at a combining node to create a combined signal at the combining node;
changing an impedance at the first output terminal of the first amplifier, by an output matching network electrically coupled to the first output terminal and electrically coupled to the combining node that includes a first tunable element, and further changing the impedance at the combining node by an impedance transformer that includes a second tunable element electrically coupled to the combining node and an output port; and
delivering the combined signal to a load electrically coupled to the output port.

**14.** The method of claim 13, wherein:

coupling a first portion of the input signal to a first input of the first amplifier and coupling a second portion of the input signal to a second input of the second amplifier includes splitting the input signal using a splitter device, wherein the first portion and second portion of the input signal are offset by a phase difference of between 60 and 120 degrees;
combining the first amplified signal and the second amplified signal includes routing the of the first amplified signal and the second amplified signal through a phase shift network that has an insertion phase that is within twenty percent of the phase difference;
amplifying the first portion of the input signal includes operating the first amplifier in a configuration from the group consisting of a peaking amplifier and a carrier amplifier; and
amplifying the second portion of the input signal includes operating the second amplifier in a configuration selected from the group consisting of a peaking amplifier and a carrier amplifier.

**15.** The method of claim 13 or 14, wherein changing the impedance at the combining node includes:

realizing a first tuning impedance, by the output matching network, and realizing a second tuning impedance, by the impedance transformer, to operate the first amplifier and the second amplifier in a first state; and
realizing a third tuning impedance, by the output matching network, and realizing a fourth tuning impedance by the impedance transformer, to operate the first amplifier and the second amplifier in a second state.

**Amended claims in accordance with Rule 137(2) EPC.**

**1.** A Doherty amplifier device (200) comprising:

an input port (202);
an output port (204);
a first amplifier (210) that includes a first input terminal (212) electrically coupled to the input port and a first output terminal (214) electrically coupled to the output port;
a second amplifier (220) that includes a second input terminal (222) electrically coupled to the input port and a second output terminal (224) electrically coupled to the output port;
a first network (260) that includes a first tunable element (350), and is electrically coupled between the first output terminal and a combining node (244); and
a second network (280) that includes a second tunable element (430), and that is electrically coupled between the combining node and the output port; and
wherein a one of: the first amplifier is configured as a peaking amplifier and the second amplifier is configured as a carrier amplifier, and the first amplifier is configured as a carrier amplifier and the second amplifier is configured as a peaking amplifier;
**characterised in that** the first tunable element of the first network and the second tunable element of the second network are reconfigurable to allow improved efficiency for low power operation.

**2.** The Doherty amplifier device of claim 1, further comprising:

a splitter network (230) that includes a splitter input, a first splitter output (232), and a second splitter output (236) that electrically couples the input port to the first input terminal at the first split output and that electrically couples the input port to the second input terminal at the second split output, wherein a first insertion phase between the splitter input and the first splitter output and a second insertion phase between the splitter input and the second splitter output have a phase difference between 60 degrees and 120 degrees; and
a phase shift network (240) electrically coupled between the second output terminal and the combining node.

**3.** The Doherty amplifier device of claim 1 or 2, wherein the first tunable element of the first network and the second tunable element of the second network are reconfigurable to increase an impedance of the peaking amplifier by a factor of $n$, in response to an n-fold reduction in the power of the Doherty Amplifier .

**4.** The Doherty amplifier device of any preceding claim, wherein the first tunable element includes a first voltage-variable capacitor (352).

5. The Doherty amplifier device of any preceding claim, wherein the first network comprises:

a first resonator (310) that includes a first shunt element (312), wherein the first resonator is electrically coupled to the first amplifier by the first shunt element;
a second shunt element (316) electrically coupled to the first shunt element and coupled to ground potential;
a first series element electrically coupled to the first resonator;
a second resonator (330) that includes a third shunt element, wherein the third shunt element is electrically coupled to the first series element; and
a fourth shunt element (338) electrically coupled to ground potential.

6. The Doherty amplifier device of claim 5, wherein:

the first shunt element includes a third tunable element (313A/B); and
the first tunable element electrically couples the third shunt element of the second resonator to the combining node.

7. The Doherty amplifier device of claim 5 or 6, wherein:

the first shunt element includes a first inductor (L1);
the second shunt element includes a capacitor (C2);
the first series element includes a second inductor (L2);
the third shunt element includes a third inductor (L3); and
the fourth shunt element includes a capacitor (C3).

8. The Doherty amplifier device of claim 7, wherein one or more of the first inductor, second inductor, and third inductor include a variable inductor.

9. The Doherty amplifier device of claim 8, wherein the first tunable element includes a voltage-variable capacitor (752), wherein:

the voltage-variable capacitor includes components selected from the group consisting of one or more varactor diodes, one or more a micro-electro-mechanical switches, and one or more PIN diodes; and
the first inductor includes components selected from the group consisting of micro-electro-mechanical switches and field effect transistor switches.

10. The Doherty amplifier device of any preceding claim, wherein the second network includes a voltage-variable impedance transmission line.

11. The Doherty amplifier device of claim 10, wherein the voltage-variable impedance transmission line includes a voltage-variable capacitor that electrically couples a transmission line to a ground potential.

12. The Doherty amplifier device of claim 11, wherein the voltage-variable capacitor is selected from the group consisting of one or more varactor diodes, one or more a micro-electro-mechanical switches, and one or more PIN diodes, barium strontium titanate devices, barium zirconate titanate devices.

13. A method of operating a Doherty amplifier device, the method comprising the steps of:

Providing (910) an input signal to an input port of the amplifier device;
coupling (920) a first portion of the input signal to a first input of a first amplifier and coupling a second portion of the input signal to a second input of a second amplifier;
amplifying (930) the first portion of the input signal with the first amplifier to create a first amplified signal at a first output terminal of the first amplifier;
amplifying (940) the second portion of the input signal with the second amplifier to create a second amplified signal at a second output terminal of the second amplifier;
combining (950) the first amplified signal and the second amplified signal at a combining node to create a combined signal at the combining node;

changing (960) an impedance at the first output terminal of the first amplifier, by an output matching network electrically coupled to the first output terminal and electrically coupled to the combining node that includes a first tunable element, and further changing the impedance at the combining node by an impedance transformer that includes a second tunable element electrically coupled to the combining node and an output port whereby the first tunable element of the first network and the second tunable element of the second network allow improved efficiency for low power operation; and

delivering (970) the combined signal to a load electrically coupled to the output port.

**14.** The method of claim 13, wherein:

coupling a first portion of the input signal to a first input of the first amplifier and coupling a second portion of the input signal to a second input of the second amplifier includes splitting the input signal using a splitter device, wherein the first portion and second portion of the input signal are offset by a phase difference of between 60 and 120 degrees;

combining the first amplified signal and the second amplified signal includes routing the of the first amplified signal and the second amplified signal through a phase shift network that has an insertion phase that is within twenty percent of the phase difference;

amplifying the first portion of the input signal includes operating the first amplifier in a configuration from the group consisting of a peaking amplifier and a carrier amplifier; and

amplifying the second portion of the input signal includes operating the second amplifier in a configuration selected from the group consisting of a peaking amplifier and a carrier amplifier.

**15.** The method of claim 13 or 14, wherein changing the impedance at the combining node includes:

realizing a first tuning impedance, by the output matching network, and realizing a second tuning impedance, by the impedance transformer, to operate the first amplifier and the second amplifier in a first state; and

realizing a third tuning impedance, by the output matching network, and realizing a fourth tuning impedance by the impedance transformer, to operate the first amplifier and the second amplifier in a second state.

EP 4 535 659 A1

FIG. 1

FIG. 2A

16

FIG. 2B

EP 4 535 659 A1

FIG. 3A

FIG. 3B

FIG. 4

FIG. 5A

FIG. 5B

FIG. 6

FIG. 7

FIG. 8

900

```
┌─────────────────────────┐
│    PROVIDE INPUT SIGNAL  │──── 910
│      TO INPUT PORT       │
└─────────────────────────┘
            │
            ▼
┌─────────────────────────┐
│    COUPLE INPUT SIGNAL   │──── 920
│   TO FIRST AMPLIFIER AND │
│     TO SECOND AMPLIFIER  │
└─────────────────────────┘
            │
            ▼
┌─────────────────────────┐
│ AMPLIFY FIRST PORTION OF │──── 930
│  INPUT SIGNAL WITH FIRST │
│         AMPLIFIER        │
└─────────────────────────┘
            │
            ▼
┌─────────────────────────┐
│ AMPLIFY SECOND PORTION OF│──── 940
│ INPUT SIGNAL WITH SECOND │
│         AMPLIFIER        │
└─────────────────────────┘
            │
            ▼
┌─────────────────────────┐
│ COMBINE FIRST AMPLIFIED  │──── 950
│ SIGNAL AND SECOND        │
│ AMPLIFIED SIGNAL AT      │
│ COMBINING NODE           │
└─────────────────────────┘
            │
            ▼
┌─────────────────────────┐
│ CHANGE IMPEDANCE AT      │──── 960
│ OUTPUTS OF FIRST         │
│ AMPLIFIER AND SECOND     │
│ AMPLIFIER WITH OUTPUT    │
│ MATCHING NETWORK AND WITH│
│ IMPEDANCE TRANSFORMER    │
└─────────────────────────┘
            │
            ▼
┌─────────────────────────┐
│ DELIVER OUTPUT SIGNAL    │──── 970
│ FROM OUTPUT PORT TO LOAD │
└─────────────────────────┘
```

FIG. 9

Europäisches
Patentamt

European
Patent Office

Office européen
des brevets

# EUROPEAN SEARCH REPORT

**Application Number**

EP 23 30 6697

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/139091 A1 (FRATTI ROGER A [US]) 29 June 2006 (2006-06-29) * paragraph [0019] – paragraph [0032]; figures 3-6 * | 1-15 | INV. H03F1/02 H03F1/56 H03F3/60 H03F3/195 H03F3/213 |
| X | US 2012/092074 A1 (YANDURU NAVEEN [US] ET AL) 19 April 2012 (2012-04-19) * paragraph [0032] – paragraph [0038] * * paragraph [0043] – paragraph [0051]; figure 5 * | 1-15 | |

TECHNICAL FIELDS
SEARCHED (IPC)

H03F

The present search report has been drawn up for all claims

| Place of search | Date of completion of the search | Examiner |
|---|---|---|
| The Hague | 19 March 2024 | Wienema, David |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 

& : member of the same patent family, corresponding
document

EPO FORM 1503 03.82 (P04C01)

EP 4 535 659 A1

## ANNEX TO THE EUROPEAN SEARCH REPORT
## ON EUROPEAN PATENT APPLICATION NO.

EP 23 30 6697

This annex lists the patent family members relating to the patent documents cited in the above-mentioned European search report.
The members are as contained in the European Patent Office EDP file on
The European Patent Office is in no way liable for these particulars which are merely given for the purpose of information.

19-03-2024

| Patent document cited in search report | Publication date | Patent family member(s) | Publication date |
|---|---|---|---|
| US 2006139091 A1 | 29-06-2006 | JP 5094017 B2 | 12-12-2012 |
| | | JP 2006191581 A | 20-07-2006 |
| | | KR 20060076246 A | 04-07-2006 |
| | | US 2006139091 A1 | 29-06-2006 |
| US 2012092074 A1 | 19-04-2012 | NONE | |

EPO FORM P0459

For more details about this annex : see Official Journal of the European Patent Office, No. 12/82

24